(19) Europäisches Patentamt
European Patent Office
Office européen des brevets

(11) **EP 3 415 658 B1**

(12) **EUROPEAN PATENT SPECIFICATION**

(45) Date of publication and mention
of the grant of the patent:
**18.11.2020 Bulletin 2020/47**

(51) Int Cl.:
***C23C 14/34*** (2006.01)        ***B22F 3/02*** (2006.01)
***B22F 3/10*** (2006.01)        ***B22F 5/10*** (2006.01)
***C22C 1/04*** (2006.01)        ***C22C 9/00*** (2006.01)
***C22C 28/00*** (2006.01)        ***B22F 9/08*** (2006.01)
***B22F 9/04*** (2006.01)

(21) Application number: **17750286.1**

(22) Date of filing: **08.02.2017**

(86) International application number:
**PCT/JP2017/004581**

(87) International publication number:
**WO 2017/138565 (17.08.2017 Gazette 2017/33)**

(54) **SPUTTERING TARGET AND METHOD FOR PRODUCING SPUTTERING TARGET**

SPUTTERTARGET UND VERFAHREN ZUR HERSTELLUNG DES SPUTTERTARGETS

CIBLE DE PULVÉRISATION CATHODIQUE, ET PROCÉDÉ DE FABRICATION DE CELLE-CI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.02.2016 JP 2016021644**
**01.02.2017 JP 2017016740**

(43) Date of publication of application:
**19.12.2018 Bulletin 2018/51**

(73) Proprietor: **Mitsubishi Materials Corporation
Chiyoda-ku
Tokyo 100-8117 (JP)**

(72) Inventors:
• **UMEMOTO Keita**
**Sanda-shi**
**Hyogo 669-1339 (JP)**
• **ZHANG Shoubin**
**Sanda-shi**
**Hyogo 669-1339 (JP)**
• **SHIONO Ichiro**
**Sanda-shi**
**Hyogo 669-1339 (JP)**
• **IO Kensuke**
**Sanda-shi**
**Hyogo 669-1339 (JP)**

(74) Representative: **Hoffmann Eitle
Patent- und Rechtsanwälte PartmbB
Arabellastraße 30
81925 München (DE)**

(56) References cited:
WO-A1-2011/083647    WO-A1-2014/117190
JP-A- 2012 082 498    JP-A- 2014 034 703
JP-A- 2014 037 556    JP-A- 2014 122 372
US-A1- 2015 332 901

**Description**

Technical Field

The present invention relates to a sputtering target used for forming a Cu-In-Ga-Se quaternary alloy thin film that forms, for example, a light-absorbing layer of a CIGS solar cell, and a method of manufacturing the sputtering target.
Priority is claimed on Japanese Patent Application No. 2016-021644, filed February 8, 2016 and Japanese Patent Application No. 2017-016740, filed February 1, 2017.

Background Art

In the related art, as a thin film solar cell formed of a compound semiconductor, a CIGS solar cell that includes a light-absorbing layer formed of a Cu-In-Ga-Se quaternary alloy thin film is provided.
Here, as a method of forming the light-absorbing layer formed of a Cu-In-Ga-Se quaternary alloy thin film, a method of forming the light-absorbing layer using a vapor deposition method is known. A solar cell that includes a light-absorbing layer formed using a vapor deposition method has an advantageous effect in that the energy conversion efficiency is high, but has a problem in that it is not suitable for an increase in area and the production efficiency is low.
Therefore, a method of forming a light-absorbing layer formed of a Cu-In-Ga-Se quaternary alloy thin film using a sputtering method is disclosed.
In the sputtering method, first, an In film is formed using an In target, and then a Cu-Ga film is formed on the In film using a Cu-Ga sputtering target. As a result, a multilayer film including the In film and the Cu-Ga film is formed. By performing a heat treatment on the multilayer film in a Se atmosphere to selenize the multilayer film, a Cu-In-Ga-Se quaternary alloy thin film is formed.
Here, regarding the Cu-In-Ga-Se quaternary alloy thin film that forms the light-absorbing layer, it is known that the conversion efficiency of a solar cell is improved by adding alkali metal such as sodium.
Therefore, as a method of adding alkali metal to a Cu-In-Ga-Se quaternary alloy thin film, for example, PTL 1 and PTL2 disclose a method of adding an alkali metal to a Cu-Ga sputtering target used for forming a Cu-Ga film.
Alkali metal is highly reactive and unstable in the form of a single substance. Therefore, in the Cu-Ga sputtering target described in PTL 1, alkali metal is added as an alkali metal compound. Specifically, in PTL 1, $Li_2O$, $Na_2O$, $K_2O$, $Li_2S$, $Na_2S$, $K_2S$, $Li_2Se$, $Na_2Se$, or $K_2Se$ is added. In particular, it is preferable that a Se compound is added.
As the sputtering target, a flat sputtering target and a cylindrical sputtering target are proposed. Here, in the flat sputtering target, one plate surface that is not joined to a back plate is a sputtering surface. In the cylindrical sputtering target, an outer peripheral surface is a sputtering surface.

Citation List

Patent Literature

[PTL 1] Republished Japanese Translation No. WO2011/083647 of the PCT International Publication for Patent Applications

[PTL2] US 2015/0332901 A1.

Summary of Invention

Technical Problem

However, recently, further improvement of the conversion efficiency of a solar cell has been required, and it is necessary that a higher concentration of alkali metal than in the related art is added to a Cu-In-Ga-Se quaternary alloy thin film that forms a light-absorbing layer. That is, in the Cu-Ga sputtering target described in PTL 1, the content of alkali metal is low, and improvement of the conversion efficiency is insufficient.
Therefore, a configuration of adding a larger amount of an alkali metal compound than in the related art to a Cu-Ga sputtering target is considered. However, alkali metal has high hygroscopicity, and thus it is difficult to add a high concentration of alkali metal to a Cu-Ga sputtering target. In addition, in a case where a large amount of an alkali metal compound is added to a Cu-Ga sputtering target, a large amount of the alkali metal compound is present in the vicinity of a sputtering surface. Here, the alkali metal compound has high hygroscopicity as described above. Therefore, in a case where the alkali metal compound is exposed to the air for a long period of time during target replacement or the like, moisture absorption occurs in a sputtering surface. As a result, a period of time required for evacuation increases, and the peak vacuum degree may decrease. In addition, metal in the target may be modified by oxidation and corrosion, and discoloration or the like may occur. Further, in order to remove a moisture absorption layer of the sputtering surface, it is necessary to increase a period of time for dummy discharge before deposition. In addition, during the dummy discharge, abnormal discharge frequently occurs due to the metal component modified by oxidation and corrosion, and there may be a case where stable sputter deposition cannot be performed. In addition, in a sputtering target having a composition that includes a large amount of a brittle intermetallic compound phase, breaking may occur in the target.

The present invention has been made in consideration of the above-described circumstances, and an object thereof is to provide: a sputtering target in which, for example, during exposure to the air for a long period of time, moisture absorption in a sputtering surface can be suppressed and sputter deposition can be stably performed; and a method of manufacturing the sputtering target.

Solution to Problem

According to one aspect of the present invention for solving the above-described problems, there is provided a sputtering target having a composition including: 5 at% or more and 60 at% or less of Ga, and 0.01 at% or more and 5 at% or less of alkali metal, as metal components; and a Cu balance including inevitable impurities, wherein a concentration of the alkali metal on a surface on a sputtering surface side is less than 80% of a concentration of the alkali metal inside the target. Here, at% of Ga and alkali metal represent the densities with respect to all the metal elements.

As an alkali metal source, for example, NaF, $Na_2S$, $Na_2Se$, NaCl, KF, $K_2S$, $K_2Se$, KCl, or KBr can be used. Among the alkali metal sources, components (for example, F, S, Se, Cl, or Br) other than alkali metal are included in Cu and inevitable impurities.

In the sputtering target according to the present invention having the above-described configuration, the alkali metal concentration of the surface on the sputtering surface side is lower than 80% with respect to the alkali metal concentration of the inside of the sputtering target. Therefore, a large amount of the alkali metal compound having high hygroscopicity is not present in the sputtering surface. For example, during exposure to the air, moisture absorption in the vicinity of the sputtering surface can be suppressed. Accordingly, evacuation can be favorably performed, a period of time for dummy discharge can be reduced, and sputter deposition can be stably performed. Further, discoloration of the sputtering target can be suppressed.

In addition, in the present invention, the sputtering target includes a composition including: 5 at% or more and 60 at% or less of Ga, and 0.01 at% or more and 5 at% or less of alkali metal, as metal components; and a Cu balance including inevitable impurities. Therefore, a Cu-Ga film including a relatively large amount of alkali metal can be formed. In addition, by performing dummy sputtering before deposition to remove the surface including a small amount of alkali metal, a Cu-Ga film including alkali metal can be reliably formed. Here, the metal in the target is not modified, and thus abnormal discharge during dummy discharge can be suppressed.

Here, in the sputtering target according to the present invention, it is preferable that the alkali metal concentration on the sputtering surface is 1 at% or less.

In this case, the alkali metal concentration of the surface on the sputtering surface which is exposed to the air is limited to be 1 at% or less. Therefore, moisture absorption in the sputtering surface can be reliably suppressed. For example, during exposure to the air, moisture absorption in the vicinity of the sputtering surface can be reliably suppressed.

In addition, in the sputtering target according to the present invention, it is preferable that a relative density is 90% or more.

In this case, the number of pores present in the sputtering target is small, the occurrence of abnormal discharge can be suppressed, and sputter deposition can be stably performed.

In addition, in the sputtering target according to the present invention, it is preferable that an arithmetic average roughness Ra of the sputtering surface is 1.6 $\mu$m or less.

In this case, the arithmetic average roughness Ra of the sputtering surface is 1.6 $\mu$m or less, and the sputtering target is relatively smoothly formed. Therefore, concentration of electric charges on a convex portion can be suppressed, and abnormal discharge can be suppressed.

In addition, it is preferable that the composition further includes one or more of metal elements selected from In, Al, Ag, Zn, Sn, Bi, Sb, and Mg as metal components in a range of 0.1 at% or more and 5.0 at% or less in total in the sputtering target according to the present invention.

In this case, the sputtering target further includes 0.1 at% or more in total of the above-described metal elements. As a result, in a case where the raw material powder including Cu and Ga is sintered to manufacture a sputtering target, the metal elements function as a sintering assistant. Therefore, the density of the sputtering target can be improved, and the occurrence of abnormal discharge can be reduced. On the other hand, the total content of the above-described metal elements is limited to be 5.0 at% or less. As a result, the occurrence of abnormal discharge caused by deposition of a metal element as a single substance can be suppressed. In addition, a deviation in the composition of a film formed in a region where a metal element is deposited can be suppressed.

The addition of the elements have no particular effects on film characteristics. However, in some cases, the power generation efficiency of a solar cell may be improved.

According to another aspect of the present invention, there is provided a method of manufacturing the above-described sputtering target, the method including: a mixing and crushing step of mixing and crushing a raw material powder including Cu and Ga, and an alkali metal compound powder to obtain a mixed powder; a sintering step of obtaining a sintered material by sintering the mixed powder obtained in the mixing and crushing step; and an alkali metal removing step of removing an alkali metal on a surface area on the sputtering surface side of the obtained sintered material, wherein the alkali metal removing step includes a machine grinding step of mechanically grinding the surface area on the sputtering surface side and an ultra-sonic washing step of ultra-sonically washing the surface area on the sputtering surface side.

The method of manufacturing the sputtering target having the above-described configuration includes the mixing and crushing step of mixing and crushing raw material powder including Cu and Ga and alkali metal compound powder to obtain mixed powder. Therefore, the alkali metal compound can be relatively uniformly dispersed in the sputtering target.

In addition, the method includes the alkali metal removing step of removing alkali metal of a region forming the sputtering surface in the obtained sintered material, and the alkali metal removing step includes the machine grinding step of mechanically grinding the region forming the sputtering surface and the ultra-sonic washing step of ultra-sonically washing the sputtering surface-side surface region. Therefore, the alkali metal compound of the sputtering surface-side surface region can be reliably removed, and the surface having a small amount of alkali metal can be reliably formed. Any one of the machine grinding step and the ultra-sonic washing step may be performed first.

Advantageous Effects of Invention

As described above, according to the present invention, it is possible to provide: a sputtering target in which, for example, during exposure to the air for a long period of time, moisture absorption in a sputtering surface can be suppressed and sputter deposition can be stably performed; and a method of manufacturing the sputtering target.

Brief Description of Drawings

FIG. 1 is a flowchart showing a method of manufacturing a sputtering target according to an embodiment of the present invention.
FIG. 2 is an image showing the external appearance of a sputtering target according to Example 5 after being left to stand in the air for 3 days.
FIG. 3 is an image showing the external appearance of a sputtering target according to Comparative Example 2 after being left to stand in the air for 3 days.

Description of Embodiments

Hereinafter, a sputtering target according to an embodiment of the present invention, and a method of manufacturing the sputtering target will be described with reference to the accompanying drawings.

The sputtering target according to the embodiment is used when a Cu-Ga thin film is formed by sputtering in order to form, for example, a light-absorbing layer formed of a Cu-In-Ga-Se quaternary alloy thin film in a CIGS thin film solar cell.

The sputtering target according to the embodiment is obtained by adding an alkali metal compound to a Cu-Ga alloy, and includes a composition including: 5 at% or more and 60 at% or less of Ga, and 0.01 at% or more and 5 at% or less of alkali metal, as metal components; and a Cu balance including inevitable impurities.

Here, the alkali metal is an element that is included in a Cu-Ga thin film formed of the sputtering target and improves the conversion efficiency of a CIGS thin film solar cell. In the embodiment, the content of the alkali metal is relatively high at 0.01 at% or more and 5 at% or less.

In the sputtering target according to the embodiment, an alkali metal concentration of a surface on a sputtering surface side is lower than 80% with respect to an alkali metal concentration of the inside of the sputtering target.

Here, the alkali metal concentration of the inside of the sputtering target is an alkali metal concentration in a surface obtained by machining the sputtering surface by 1 mm or more through a dry process.

In the embodiment, the alkali metal concentration of the surface on the sputtering surface is 1 at% or less.

Further, in the sputtering target according to the embodiment, a relative density is 90% or more, and an arithmetic average roughness Ra of the sputtering surface is 1.6 $\mu$m or less.

In addition, optionally, the composition of the sputtering target according to the embodiment may further include one or more of metal elements selected from In, Al, Ag, Zn, Sn, Bi, Sb, and Mg as metal components in a range of 0.1 at% or more and 5.0 at% or less in total

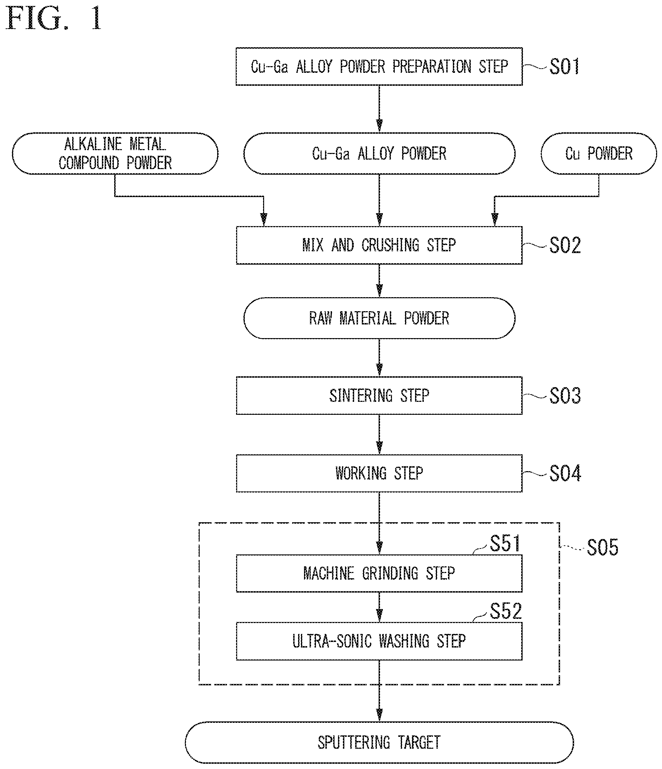

Next, the method of manufacturing the sputtering target according to the embodiment will be described with reference to a flowchart of FIG. 1.

As shown in FIG. 1, the method of manufacturing the sputtering target according to the embodiment includes: a Cu-Ga alloy powder preparing step S01 of preparing Cu-Ga alloy powder; a mixing and crushing step S02 of obtaining raw material powder by mixing and crushing the Cu-Ga alloy powder, Cu powder, and alkali metal compound powder; a sintering step S03 of heating the raw material powder to be sintered; a machining step S04 of machining the obtained sintered material; and an alkali metal removing step S05 of removing alkali metal of a sputtering surface-side surface region in the obtained processed sintered material.

The raw material powder is mixed powder obtained by mixing the alkali metal compound powder, the Cu-Ga alloy powder, and the Cu powder with each other.

Here, as the alkali metal compound powder, commercially available alkali metal compound powder having a purity of 99 mass% or more and an average grain size of 5 to 500 $\mu$m is preferably used. As the alkali metal compound powder, for example, NaF, $Na_2S$, $Na_2Se$, NaCl, KF, $K_2S$, $K_2Se$, KCl, or KBr can be used.

Here, as the Cu powder, commercially available Cu powder having a purity of 99.9 mass% or more and an average grain size of 5 to 500 $\mu$m is preferably used.

Further, as the Cu-Ga alloy powder, atomized powder manufactured in the Cu-Ga alloy powder preparing step S01 described below is used. The composition ratio is Ga: 5 to 60 mass% and a balance including Cu and inevitable impurities. In addition, an average grain size of the Cu-Ga alloy powder is in a range of 5 to 50 $\mu$m.

The raw material powder may further include one or more metal elements selected from the group consisting of In, Al, Ag, Zn, Sn, Bi, Sb, and Mg as metal components such that the total content of the one or more metal elements in the sintered material after sintering is in a range of 0.1 at% or more and 5.0 at% or less.

(Cu-Ga Alloy Powder Preparing Step S01)

First, in the Cu-Ga alloy powder preparing step S01, a massive Cu raw material and a massive Ga raw material are weighed to obtain a predetermined composition and are put into a crucible formed of carbon, and this crucible is set in a gas atomization device. For example, the raw materials are melted by being evacuated up to $10^{-2}$ Pa or less and being held under a temperature condition of 1000°C to 1200°C for 1 minute to 30 minutes. Next, while causing the molten alloy to drop through nozzles having a pore size of 1 mm to 3 mm, Ar gas is injected at a gas injection pressure of 10 kgf/$cm^2$ to 50 kgf/$cm^2$. As a result, gas atomized powder is prepared. The obtained gas atomized powder is cooled and then classified through a sieve having a pore size of 10 to 250 $\mu$m. As a result, Cu-Ga alloy powder having a predetermined grain size is obtained.

Depending on the composition ratio between Cu and Ga, due to its high injection temperature, the molten alloy may reach a chamber before solidified into powder. In this case, it is preferable that the injection temperature is set to be lower than a heating and holding temperature by about 100°C to 400°C.

(Mixing and Crushing Step S02)

Next, the alkali metal compound powder, the Cu-Ga alloy powder, and optionally the Cu powder are weighed to obtain a predetermined composition and are mixed and crushed using a mixing crusher to obtain raw material powder.

Here, in a case where a ball mill is used as the mixing crusher, it is preferable that 5 kg of zirconia balls having a diameter of 5 mm and 3 kg of the mixing objects (the alkali metal compound powder, the Cu-Ga alloy powder, the Cu powder) were put into, for example, a 10 L pot filled with inert gas such as Ar, and were mixed and crushed at 85 to 135 rpm for an operation time of 3 to 16 hours.

In addition, in a case where a Henschel mill is used as the mixing crusher, for example, it is preferable that the mixing objects were mixed and crushed in an inert gas atmosphere such as Ar at a rotation speed of 2000 to 3000 rpm for an operation time of 1 to 5 minutes.

A mixing crusher such as a V-type mixer or a rocking mixer that mainly acts for mixing is not preferable because it may be insufficient for crushing the alkali metal compound powder.

(Sintering Step S03)

Next, the raw material powder (mixed powder) obtained as described above is sintered in a vacuum, an inert gas atmosphere, or a reducing atmosphere. In the embodiment, for example, pressureless sintering, hot pressing, or hot isostatic pressing can be applied.

In the case of pressureless sintering, the presence of hydrogen in the atmosphere is advantageous in improving sinterability, and the hydrogen content in the atmosphere is preferably 1 vol% or more. In addition, not only hydrogen but also reducing gas such as carbon monoxide or ammonia cracking gas or mixed gas of reducing gas and inert gas may be used.

In addition, in the case of hot pressing and hot isostatic pressing, the pressing pressure has an effect on the density of the sintered material. Therefore, the pressing pressure is preferably in a range of 10 MPa to 60 MPa. Pressing may be performed before the start of an increase in temperature, or may be performed after a predetermined temperature is reached.

Here, in a case where the raw material powder includes 0.1 at% or more and 5.0 at% or less in total of one or more metal elements selected from the group consisting of In, Al, Ag, Zn, Sn, Bi, Sb, and Mg, the metal elements function as a sintering assistant.

(Machining Step S04)

A sputtering target having a predetermined shape is obtained by cutting or grinding the sintered material obtained in the sintering step S03.

(Alkali Metal Removing Step S05)

Next, alkali metal of a sputtering surface-side surface region in the obtained sintered material is removed. As shown in FIG. 1, the alkali metal removing step S05 includes: a machine grinding step S51 of mechanically grinding the sputtering surface-side surface region and an ultra-sonic washing step S52 of ultra-sonically washing the polished surface after the machine grinding step S51.

In the machine grinding step S51, the sputtering surface of the sputtering surface is removed using a fine sandpaper having a roughness of 1000 grit or more while applying pure water thereto as an alkali metal remover. Specifically, it is preferable that, while supplying pure water at a supply amount of 100 mL/min or more, the sputtering surface-side surface region is mechanically polished using a sandpaper of 1000 grits or more for 5 to 30 minutes under a load such that the grinding amount is 5 $\mu$m/min or less.

At this time, in a case where the supply amount of pure water is small, the alkali metal of the sputtering surface may not be sufficiently removed. In addition, in a case where the grit number of the sandpaper is excessively high, the sputtering surface may be excessively roughened, which may cause abnormal discharge during sputtering. Therefore, in the embodiment, the machine grinding step S51 is performed under the above-described conditions.

The sandpaper is merely exemplary. Instead of using the sandpaper, grinding with which the same effects can be obtained can also be adopted.

In the ultra-sonic washing step S52, using an ultra-sonic cleaner filled with pure water, vibration (ultra-sonic wave) is applied to the sintered material after the machine grinding step S51 to remove alkali metal which is not removed in the machine grinding step. At this time, using pure water having a volume which is less than 10 times the volume of the sintered material, washing was performed for 5 to 40 minutes. While replacing pure water, ultra-sonic washing was repeated until a variation between the pH before washing and the pH after washing reached lower than 5%. At this time, in order to efficiently remove alkali metal, it is more preferable that ultrapure water is used. In addition, it is not preferable that an acid or an alkali is used as a washing solution because gas may be produced due to a reaction with the alkali metal compound.

After ultra-sonic washing, water attached to the surface was blown away by dry air to be dried in the air, preferably, in a desiccator.

Through the above-described steps, the sputtering target according to the embodiment is manufactured. The sputtering target is used after being bonded to a back plate formed of Cu, stainless steel (SUS), or another metal (for example, Mo) by using In as a solder.

In the sputtering target according to the embodiment having the above-described configuration, the alkali metal concentration of the surface on the sputtering surface side is lower than 80% with respect to the alkali metal concentration of the inside of the sputtering target. Therefore, a large amount of the alkali metal compound having high hygroscopicity is not present in the sputtering surface-side surface region. For example, during exposure to the air, moisture absorption in the vicinity of the sputtering surface can be suppressed. Accordingly, evacuation can be favorably performed, a period of time for dummy discharge can be reduced, and sputter deposition can be stably performed. Further, discoloration of the sputtering target can be suppressed.

In the embodiment, the alkali metal concentration of the inside of the sputtering target is an alkali metal concentration in a surface obtained by machining the sputtering surface by 1 mm or more through a dry process, and the alkali metal concentration of the sputtering surface is sufficiently lower than that of the inside of the sputtering target.

In addition, in the embodiment, the sputtering target has a composition including: 5 at% or more and 60 at% or less of Ga, and 0.01 at% or more and 5 at% or less of alkali metal, as metal components; and a Cu balance including inevitable impurities. Therefore, a Cu-Ga film including a relatively large amount of alkali metal can be formed. In addition, by performing dummy sputtering before deposition to remove the surface including a small amount of alkali metal, a Cu-Ga film including alkali metal can be reliably formed. In the sputtering target according to the embodiment, moisture absorption is suppressed, and the metals in the target are not modified. Therefore, during dummy discharge before sputter deposition, the occurrence of abnormal discharge can be suppressed.

In addition, in the sputtering target according to the embodiment, the alkali metal concentration of the surface on the sputtering surface is 1 at% or less. Therefore, moisture absorption in the sputtering surface can be reliably suppressed. For example, during exposure to the air, moisture absorption in the vicinity of the sputtering surface can be reliably suppressed.

Further, in the sputtering target according to the embodiment, a relative density is 90% or more. Therefore, the number of pores present in the sputtering target is small, the occurrence of abnormal discharge can be suppressed, and sputter deposition can be stably performed.

In addition, in the sputtering target according to the embodiment, the arithmetic average roughness Ra of the sputtering surface is 1.6 $\mu$m or less, and the sputtering target is relatively smoothly formed. Therefore, concentration of electric charges on a convex portion can be suppressed, and abnormal discharge can be suppressed.

Further, in a case where the composition of the sputtering target according to the embodiment further includes one or more of metal elements selected from In, Al, Ag, Zn, Sn, Bi, Sb, and Mg as metal components in a range of 0.1 at% or more and 5.0 at% or less in total, the metal elements function as a sintering assistant. Therefore, the density of the sputtering target can be improved, the occurrence of abnormal discharge can be reduced, the occurrence of abnormal discharge caused by deposition of a metal element as a single substance can be suppressed, and a deviation in the composition of a film formed in a region where a metal element is deposited can be suppressed.

In order to further improve the density, the lower limit of the total content of the metal elements is preferably 0.5 at% or more. On the other hand, in order to suppress deposition of a metal element as a single substance, the upper limit of the total content of the metal elements is preferably 3.0 at% or more.

In addition, the method of manufacturing the sputtering target according to the embodiment includes the mixing and crushing step S02 of mixing and crushing raw material powder including Cu and Ga and alkali metal compound powder to obtain mixed powder. Therefore, the alkali metal compound can be relatively uniformly dispersed in the sputtering target.

Further, the method of manufacturing the sputtering target includes the alkali metal removing step S05 of removing alkali metal of a sputtering surface-side surface region in the obtained sintered material, and the alkali metal removing step S05 includes the machine grinding step S51 of mechanically grinding the sputtering surface-side surface region and the ultra-sonic washing step S52 of ultra-sonically washing the polished surface after the machine grinding step S51. Therefore, the alkali metal compound of the surface on the sputtering surface side can be reliably removed, and the surface having a small amount of alkali metal can be reliably formed.

Hereinabove, the embodiment of the present invention has been described. However, the present invention is not limited to the embodiment, and various modifications can be made within a range not departing from the technical ideas of the present invention.

For example, in the above description of the embodiment, the raw material powder is mixed powder obtained by mixing the alkali metal compound powder, the Cu-Ga alloy powder, and the Cu powder with each other. However, the present invention is not limited to this configuration, and the Cu powder is not necessarily used. It is preferable that the use of the Cu powder is appropriately selected according to the composition of the sputtering target.

In addition, the present invention is not limited to the facilities used in the embodiment. The sputtering target according to the embodiment may be manufactured by appropriately using existing facilities.

[Examples]

Hereinafter, the results of an evaluation test for evaluating the effects of the sputtering target according to the present invention and the method of manufacturing the sputtering target will be described.

<Sputtering Target>

First, Cu-Ga alloy powder, Cu powder, and alkali metal compound powder were prepared as raw material powder. The components were weighed to obtain a composition shown in Table 1, and the mixing and crushing step, the sintering step, and the machining step were performed under the conditions described in the embodiment. As a result, a sintered material having a target shape of 126 mm×178mm×6 mmt was obtained. Hereinafter, a specific manufacturing method will be described.

First, in the Cu-Ga alloy powder preparing step S01, massive Cu raw material having a purity of 4 N and massive Ga raw material having a purity of 4 N were weighed such that the content of Ga was 50 at%, and the raw materials were dissolved by being held at 1100°C for 5 minutes by gas atomization. Next, while causing the molten alloy to drop through nozzles having a pore size of 1.5 mm, Ar gas was injected at a gas injection pressure of 25 kgf/cm$^2$. As a result, gas atomized powder was prepared. The obtained gas atomized powder was cooled and then classified through a sieve having a pore size of 125 $\mu$m. As a result, Cu-Ga alloy powder having a predetermined grain size was obtained.

Next, alkali metal compound powder having a purity of 2 N, Cu-Ga alloy powder, and Cu powder having a purity of 3 N shown in Table 1 were weighed such that a composition shown in Table 1 was obtained and the total weight was 2 kg. Next, the compounds were mixed and crushed using a ball mill filled with Ar gas at 90 rpm for 16 hours to obtain raw material powder.

Next, using a hot pressing machine, the obtained raw material powders (mixed powders) were treated at a set pressing pressure of 25 MPa and at a temperature 800°C in Examples 1, 5, 6, 10, 12, 13, 15, and 16 and Comparative Examples 1 and 3, at a temperature of 750°C in Examples 2, 3, 8, and 9 and Comparative Examples 2, 4, 5, and 6, and at a temperature of 650°C in Examples 4, 7, 11, and 14, respectively, for 2 hours.

Each of the obtained sintered bodies was ground, As a result, a target of 126 mm×178 mm×6 mmt was obtained.

The alkali metal removing step was performed under conditions shown in Table 2. In Comparative Examples 1 and 2, the alkali metal removing step was not performed. In addition, in Comparative Example 3, only ultra-sonic washing was performed. In Comparative Example 5, only the machine grinding step was performed.

The obtained sputtering target was evaluated as follows. The evaluation results are shown in Tables 1 and 3.

<Relative Density>

The density was measured using the Archimedes' principle, a density $\rho_{Cu}$ of pure copper of 8.96 g/cm$^3$ and a density $\rho_{CuGa}$ of the Cu-Ga alloy (Cu: 69.23 at%, Ga: 30.77 at%) of 8.47 g/cm$^3$ were connected through a straight line, a value obtained by interpolation or extrapolation according to the composition of the Cu-Ga alloy (Ga content) was calculated as 100%. Based on this value, the relative density was calculated.

<Alkali Metal Concentration of Surface and Alkali Metal Concentration Ratio>

Regarding a sputtering surface of the obtained sputtering target, metal components including alkali metal in the sputtering surface were measured by laser ablation ICP-MS (LA-ICP-MS). Based on the obtained concentrations of the metal components, the alkali metal concentration (at%) was calculated, and the alkali metal concentration of the sputtering surface was obtained. In a case where a central coordinate of the sputtering surface was represented by (X=0 mm, Y=0 mm), samples were collected from five positions of (X=-70 mm, Y=50 mm), (X=-70 mm, Y=-50 mm), (X=0 mm, Y=0 mm), (X=70 mm, Y=50 mm), and (X=70 mm, Y=-50 mm), and the average value of the measurement results was set as "Alkali Metal Concentration of Surface". At this time, in a case where the alkali metal concentration was a lower detection limit or less, this value was shown as 0. Laser conditions were, for example, beam diameter: 100 $\mu$m, pulse period: 10 Hz, laser power: 2 mj, scanning speed: 50 $\mu$m/sec, and analysis area: 1 mm×1 mm. The laser conditions were appropriately adjusted according to the surface state or composition of the sample. Further, after machining the sputtering surface by 1 mm or more through a dry process, the average value of samples collected from five positions was measured as "Alkali Metal Concentration of Inside". Based on the alkali metal concentrations, "Surface Alkali Metal Concentration Ratio" was calculated using the following calculation expression.

$$\text{Surface Alkali Metal Concentration Ratio (\%)} = \text{(Alkali Metal Concentration of Surface)/(Alkali Metal Concentration of Inside)} \times 100$$

<Surface Roughness Ra of Sputtering Surface>

Regarding the sputtering surface of the sputtering target, a surface roughness Ra in a direction perpendicular to a machined surface was measured using a surface roughness tester (Mitsutoyo Surf Test SV-3000).

<Evaluation of External Appearance after Storage in Air for 3 Days>

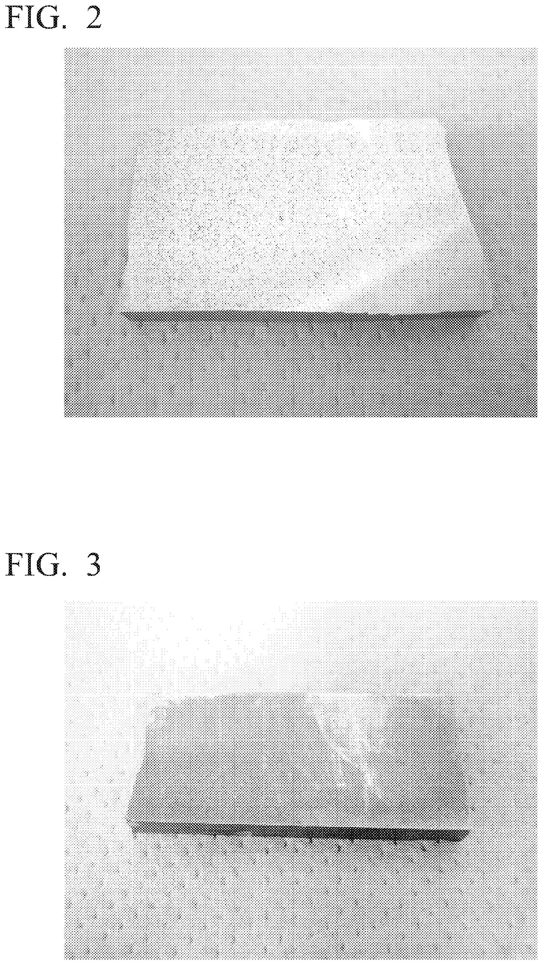

A fragment of the prepared sputtering target was left to stand in the air (temperature: 15°C to 35°C, humidity: 20 to 60%) for 3 days. A case where the sputtering target after the storage was not discolored compared to the sputtering target before the storage was evaluated as "A", a case where the sputtering target after the storage was discolored yellow as a whole or was discolored in the form of light yellow speckles compared to the sputtering target before the storage was evaluated as "B", and a case where the sputtering target after the storage was discolored from dark yellow to black compared to the sputtering target before the storage was evaluated as "C". FIG. 2 shows the result of observing the external appearance of Example 5, and FIG. 3 shows the result of observing the external appearance of Comparative Example 2.

<Evaluation of Evacuation Time>

The prepared sputtering target was mounted on a sputtering device, and was evacuated for 12 hours using an evacuation system including a turbomolecular pump and a rotary pump. At this time, the degree of vacuum was recorded.

<Evaluation of Abnormal Discharge during Initial Sputtering>

After the evacuation, sputtering was performed under conditions of sputtering gas: Ar gas, flow rate: 50 sccm, pressure: 0.67 Pa, and input power: 2 W/cm$^2$ for 30 minutes, and the number of times of abnormal discharge was measured using an arc counting function of a DC power supply. As the DC power supply, for example, HPK06Z-SW6 (manufactured by Kyosan Electric Mfg. Co., Ltd.) was used.

[Table 1]

| | Composition of Metal Components (at%) | | | | | | | | | | | | | |
| | Ga | Na | K | In | Al | Ag | Zn | Sn | Bi | Sb | Mg | Cu and Inevitable Impurities | Alkali Metal Compound | Relative Density (%) |
|---|---|---|---|---|---|---|---|---|---|---|---|---|---|---|
| 1 | 25 | 5.0 | - | - | - | - | - | - | - | - | - | Balance | NaF | 97 |
| 2 | 30 | 0.5 | - | - | - | - | - | - | - | - | - | Balance | $Na_2S$ | 98 |
| 3 | 35 | 1.0 | - | - | - | - | - | - | - | - | - | Balance | $Na_2Se$ | 93 |
| 4 | 40 | 4.0 | - | - | - | - | - | - | - | - | - | Balance | NaCl | 94 |
| 5 | 20 | - | 2.0 | - | - | - | - | - | - | - | - | Balance | KF | 95 |
| 6 | 15 | - | 3.0 | - | - | - | - | - | - | - | - | Balance | $K_2S$ | 96 |
| 7 | 40 | - | 1.0 | - | - | - | - | - | - | - | - | Balance | $K_2Se$ | 92 |
| 8 | 35 | - | 3.0 | - | - | - | - | - | - | - | - | Balance | KCl | 95 |
| 9 | 30 | - | 2.0 | - | - | - | - | - | - | - | - | Balance | KBr | 96 |
| 10 | 10 | 3.0 | 1.0 | - | - | - | - | - | - | - | - | Balance | $Na_2S \cdot KF$ | 94 |
| 11 | 25 | 5.0 | - | - | - | - | - | - | - | - | - | Balance | NaF | 85 |
| 12 | 25 | 5.0 | - | - | - | - | - | - | - | - | - | Balance | NaF | 93 |
| 13 | 25 | 5.0 | - | 3.0 | - | - | - | - | - | - | - | Balance | NaF | 92 |
| 14 | 20 | - | 2.0 | - | 2.0 | - | - | - | - | - | - | Balance | KF | 87 |
| 15 | 20 | - | 2.0 | - | - | 1.0 | - | - | - | - | - | Balance | KF | 93 |
| 16 | 20 | - | 2.0 | - | - | - | 2.5 | - | - | - | - | Balance | KF | 95 |
| 17 | 35 | - | 1.0 | - | - | - | - | 5.0 | - | - | - | Balance | KF | 98 |
| 18 | 40 | 5.0 | - | - | - | - | - | - | 3.0 | - | - | Balance | NaF | 96 |
| 19 | 35 | 3.0 | - | - | - | - | - | - | - | 4.0 | - | Balance | $Na_2S$ | 95 |
| 20 | 30 | - | 2.0 | - | - | - | - | - | - | - | 1.0 | Balance | KF | 97 |
| 21 | 30 | - | 5.0 | - | - | - | - | - | - | - | - | Balance | KCl | 98 |
| 22 | 25 | 3.0 | - | - | - | - | - | - | - | - | - | Balance | NaF | 98 |
| 23 | 30 | 5.0 | - | - | - | - | - | - | - | - | - | Balance | $Na_2S$ | 99 |
| 24 | 40 | - | 2.0 | - | - | - | - | - | - | - | - | Balance | KF | 95 |

Example of the present invention

(continued)

| | | Composition of Metal Components (at%) | | | | | | | | | | | Alkali Metal Compound | Relative Density (%) |
|---|---|---|---|---|---|---|---|---|---|---|---|---|---|---|---|
| | | Ga | Na | K | In | Al | Ag | Zn | Sn | Bi | Sb | Mg | Cu and Inevitable Impurities | | |
| | 25 | 35 | - | 1.0 | - | - | 0.5 | - | - | 1.0 | - | - | Balance | KCl | 97 |
| Comparative Example | 1 | 20 | 4.0 | - | - | - | - | - | - | - | - | - | Balance | $Na_2Se$ | 92 |
| | 2 | 30 | - | 1.0 | - | - | - | - | - | - | - | - | Balance | KF | 93 |
| | 3 | 25 | 1.0 | - | - | - | - | - | - | - | - | - | Balance | NaF | 92 |
| | 4 | 35 | - | 4.0 | - | - | - | - | - | - | - | - | Balance | $K_2S$ | 94 |
| | 5 | 33 | 2.0 | - | - | - | - | - | - | - | - | - | Balance | NaF | 96 |
| | 6 | 35 | - | 4.0 | - | - | - | - | - | - | - | - | Balance | $K_2S$ | 94 |
| | 7 | 30 | - | 1.0 | - | 2.0 | - | - | - | - | - | - | Balance | KF | 96 |
| | 8 | 30 | - | 2.0 | - | - | 1.0 | - | - | - | - | - | Balance | KF | 94 |
| | 9 | 30 | - | 1.0 | - | - | - | 2.5 | - | - | - | - | Balance | KF | 96 |
| | 10 | 25 | 3.0 | - | - | - | - | - | 5.0 | - | - | - | Balance | NaF | 98 |
| | 11 | 35 | - | 4.0 | - | - | - | - | - | 3.0 | - | - | Balance | $K_2S$ | 97 |
| | 12 | 33 | 2.0 | - | - | - | - | - | - | - | 4.0 | - | Balance | NaF | 96 |
| | 13 | 35 | - | 4.0 | - | - | - | - | - | - | - | 1.0 | Balance | $K_2S$ | 93 |
| | 14 | 30 | - | 4.0 | 2.0 | - | - | - | - | - | - | - | Balance | $K_2S$ | 96 |
| | 15 | 25 | 2.0 | - | 6.0 | - | - | - | - | - | - | - | Balance | NaF | 99 |
| | 16 | 40 | - | 4.0 | - | - | - | - | 7.0 | - | - | - | Balance | $K_2S$ | 99 |

[Table 2]

| | | Mechanical Grinding Conditions | | | Ultra-sonic Washing Conditions | | |
|---|---|---|---|---|---|---|---|
| | | Pure Water Supply Amount (ml/min) | Grit Number of Sandpaper | Grinding Time (min) | Time (min) | Number of Times | pH Change before and after Washing |
| Example of the present invention | 1 | 100 | 1000 | 15 | 30 | 3 | 3 |
| | 2 | 200 | 2000 | 10 | 20 | 1 | 0 |
| | 3 | 100 | 1000 | 10 | 40 | 1 | 3 |
| | 4 | 10 | 2000 | 20 | 30 | 7 | 2 |
| | 5 | 200 | 4000 | 10 | 30 | 3 | 4 |
| | 6 | 200 | 2000 | 25 | 40 | 3 | 2 |
| | 7 | 50 | 1000 | 10 | 30 | 5 | 1 |
| | 8 | 100 | 2000 | 20 | 30 | 3 | 2 |
| | 9 | 200 | 3000 | 15 | 15 | 2 | 3 |
| | 10 | 100 | 2000 | 10 | 30 | 1 | 2 |
| | 11 | 100 | 1000 | 15 | 30 | 3 | 5 |
| | 12 | 100 | 240 | 15 | 30 | 3 | 7 |
| | 13 | 50 | 4000 | 5 | 15 | 1 | 9 |
| | 14 | 200 | 4000 | 10 | 30 | 3 | 6 |
| | 15 | 200 | 240 | 15 | 30 | 1 | 10 |
| | 16 | 100 | 2000 | 5 | 15 | 1 | 10 |
| | 17 | 200 | 2000 | 20 | 30 | 1 | 2 |
| | 18 | 100 | 1000 | 10 | 30 | 3 | 0 |
| | 19 | 200 | 2000 | 5 | 30 | 1 | 3 |
| | 20 | 50 | 1000 | 20 | 30 | 2 | 2 |
| | 21 | 100 | 2000 | 20 | 15 | 3 | 3 |
| | 22 | 100 | 2000 | 5 | 15 | 3 | 4 |
| | 23 | 200 | 4000 | 10 | 30 | 5 | 0 |
| | 24 | 50 | 2000 | 10 | 15 | 2 | 5 |
| | 25 | 100 | 240 | 10 | 15 | 1 | 7 |
| Comparative Example | 1 | None | | | | | |
| | 2 | None | | | | | |
| | 3 | None | | | 5 | 1 | 10 |
| | 4 | 100 | 2000 | 10 | 10 | 1 | 7 |
| | 5 | 100 | 1000 | 15 | None | | |
| | 6 | 100 | 200 | 10 | 10 | 1 | 8 |
| | 7 | None | | | | | |
| | 8 | None | | | | | |
| | 9 | None | | | | | |
| | 10 | 100 | 1000 | 15 | | | |

(continued)

| | | Mechanical Grinding Conditions | | | Ultra-sonic Washing Conditions | | |
|---|---|---|---|---|---|---|---|
| | | Pure Water Supply Amount (ml/min) | Grit Number of Sandpaper | Grinding Time (min) | Time (min) | Number of Times | pH Change before and after Washing |
| | 11 | None | | | 5 | 1 | 10 |
| | 12 | 100 | 200 | 10 | 10 | 1 | 7 |
| | 13 | None | | | | | |
| | 14 | None | | | 5 | 1 | 10 |
| | 15 | 100 | 1000 | 10 | 30 | 3 | 0 |
| | 1 6 | 200 | 2000 | 5 | 30 | 1 | 3 |

[Table 3]

| | | Alkali Metal Concentration on Surface | | Alkali Metal Concentration Ratio (Surface/Inside) | | Surface Roughness Ra (μm) | External Appearance after Storage in Air for 3 Days | Peak Vacuum Degree After Evacuation for 12 Hours (Pa) | Number of Times of Abnormal Discharge during Initial Sputtering (count/30 min) |
|---|---|---|---|---|---|---|---|---|---|
| | | Na (at%) | K (at%) | Na (%) | K (%) | | | | |
| Example of the present invention | 1 | 0.9 | - | 18 | - | 1.1 | B | 3.2E-04 | 0 |
| | 2 | 0 | - | 0 | - | 0.9 | A | 2.3E-04 | 2 |
| | 3 | 0.7 | - | 66 | - | 1.2 | A | 3.6E-04 | 4 |
| | 4 | 1.4 | - | 35 | - | 0.9 | B | 2.2E-04 | 5 |
| | 5 | - | 0.6 | - | 29 | 0.7 | B | 4.6E-04 | 3 |
| | 6 | - | 0 | - | 0 | 0.8 | A | 3.8E-04 | 0 |
| | 7 | 7-0-0 | 0 | 7-0-0 | 0 | 1.0 | A | 2.9E-04 | 1 |
| | 8 | 8-0-0 | 0 | 8-0-0 | 0 | 1.0 | A | 2.7E-04 | 0 |
| | 9 | - | 1.5 | - | 75 | 0.8 | B | 4.4E-04 | 5 |
| | 10 | 0.6 | 0 | 21 | 0 | 1.0 | A | 3.0E-04 | 1 |
| | 11 | 1.3 | - | 26 | - | 1.3 | B | 5.3E-04 | 21 |
| | 12 | 1.4 | - | 28 | - | 1.8 | B | 5.1E-04 | 9 |
| | 13 | 3.9 | - | 78 | - | 0.9 | B | 6.7E-04 | 21 |
| | 14 | - | 0.9 | - | 45 | 1.1 | B | 5.3E-04 | 27 |
| | 15 | - | 1.5 | - | 75 | 1.7 | B | 6.6E-04 | 19 |
| | 16 | - | 1.4 | - | 70 | 0.8 | B | 7.0E-04 | 22 |
| | 17 | - | 0.2 | - | 20 | 0.9 | A | 5.3E-04 | 0 |
| | 18 | 0.0 | - | 0 | - | 1.1 | A | 2.3E-04 | 0 |
| | 19 | 0.6 | - | 20 | - | 0.8 | B | 4.6E-04 | 3 |
| | 20 | - | 0.2 | - | 10 | 0.9 | A | 3.0E-04 | 1 |
| | 21 | - | 1.2 | - | 24 | 0.8 | B | 4.6E-04 | 4 |
| | 22 | 1.2 | - | 40 | - | 1.0 | B | 5.3E-04 | 12 |

(continued)

| | | Alkali Metal Concentration on Surface | | Alkali Metal Concentration Ratio (Surface/Inside) | | Surface Roughness Ra (μm) | External Appearance after Storage in Air for 3 Days | Peak Vacuum Degree After Evacuation for 12 Hours (Pa) | Number of Times of Abnormal Discharge during Initial Sputtering (count/30 min) |
|---|---|---|---|---|---|---|---|---|---|
| | | Na (at%) | K (at%) | Na (%) | K (%) | | | | |
| | 23 | 0.0 | - | 0 | - | 0.9 | A | 2.3E-04 | 0 |
| | 24 | - | 1.3 | - | 65 | 0.9 | B | 6.6E-04 | 16 |
| | 25 | - | 0.7 | - | 70 | 0.8 | B | 7.0E-04 | 21 |
| Comparati ve Example | 1 | 4.0 | - | 100 | - | 1.2 | C | 1.8E-03 | 105 |
| | 2 | - | 1.0 | - | 100 | 1.4 | C | 1.3E-03 | 73 |
| | 3 | 0.9 | - | 91 | - | 1.1 | C | 4.7E-04 | 45 |
| | 4 | - | 3.3 | - | 83 | 0.9 | C | 5.0E-04 | 67 |
| | 5 | 1.7 | - | 84 | - | 1.2 | C | 7.6E-04 | 54 |
| | 6 | - | 3.4 | - | 85 | 1.7 | C | 4.5E-03 | 93 |
| | 7 | - | 1.0 | - | 100 | 1.5 | C | 8.7E-04 | 58 |
| | 8 | - | 2.0 | - | 100 | 1.3 | C | 9.5E-04 | 76 |
| | 9 | - | 1.0 | - | 100 | 1.4 | C | 1.1E-03 | 66 |
| | 10 | 2.5 | - | 83 | - | 1.2 | C | 8.2E-04 | 84 |
| | 11 | - | 3.5 | - | 88 | 1.8 | C | 7.9E-04 | 101 |
| | 12 | 1.7 | - | 85 | - | 1.8 | C | 9.8E-04 | 94 |
| | 13 | - | 4.0 | - | 100 | 1.9 | C | 1.3E-03 | 112 |
| | 14 | - | 3.5 | - | 88 | 1.7 | C | 9.9E-04 | 129 |
| | 15 | 1.7 | - | 85 | - | 1.0 | A | 4.7E-04 | 146 |
| | 16 | - | 4.0 | - | 100 | 1.2 | B | 6.7E-04 | 189 |

In Comparative Examples where the alkali metal concentration in the sputtering surface-side surface region was lower than 80% with respect to the alkali metal concentration of the inside of the sputtering target and where the surface having a small amount of alkali metal was not formed, discoloration after the storage in the air was recognized, and the number of times of abnormal discharge during the initial sputtering was large. In addition, the peak vacuum degree was also insufficient.

On the other hand, in Examples where the alkali metal concentration of the surface on the sputtering surface side was lower than 80% with respect to the alkali metal concentration of the inside of the sputtering target, discoloration after the storage in the air was suppressed, the peak vacuum degree was also sufficient, and the number of times of abnormal discharge during the initial sputtering was small.

In addition, in Examples 11 and 14, the relative density was lower than 90%. In Examples 12 and 15, the arithmetic average roughness Ra of the sputtering surface was higher than 1.6 $\mu$m, and it was found that the number of times of abnormal discharge was slightly large. Therefore, the relative density is preferably 90% or more, and the arithmetic average roughness Ra of the sputtering surface is preferably 1.6 $\mu$m or less.

Based on the above results, the following was found. According to Examples, it is possible to provide: a sputtering target in which, for example, during exposure to the air for a long period of time, moisture absorption in a sputtering surface can be suppressed and sputter deposition can be stably performed; and a method of manufacturing the sputtering target.

Industrial Applicability

Surface deterioration of a Cu-Ga sputtering target including a larger amount of an alkali metal compound than that in the related art can be prevented, and a Cu-In-Ga-Se quaternary alloy thin film that forms a light-absorbing layer of a CIGS solar cell or the like can be more stably formed.

Reference Signs List

S05: ALKALI METAL REMOVING STEP
S51: MACHINE GRINDING STEP
S52: ULTRA-SONIC WASHING STEP

**Claims**

1. A sputtering target having a composition comprising: 5 at% or more and 60 at% or less of Ga, and 0.01 at% or more and 5 at% or less of alkali metal, as metal components; optionally, one or more of metal elements selected from In, A1, Ag, Zn, Sn, Bi, Sb, and Mg as metal components in a range of 0.1 at% or more and 5.0 at% or less in total; and a Cu balance including inevitable impurities, wherein a concentration of the alkali metal on a surface on a sputtering surface side is less than 80% of a concentration of the alkali metal inside the target.

2. The sputtering target according to claim 1, wherein the alkali metal concentration on the sputtering surface is 1 at% or less.

3. The sputtering target according to claim 1 or 2, wherein a relative density is 90% or more.

4. The sputtering target according to any one of claims 1 to 3, wherein an arithmetic average roughness Ra of the sputtering surface is 1.6 $\mu$m or less.

5. A method of manufacturing the sputtering target according to any one of claims 1 to 4, the method comprising:

   a mixing and crushing step of mixing and crushing a raw material powder including Cu and Ga, and an alkali metal compound powder to obtain a mixed powder;
   a sintering step of obtaining a sintered material by sintering the mixed powder obtained in the mixing and crushing step; and
   an alkali metal removing step of removing an alkali metal on a surface area on the sputtering surface side of the obtained sintered material,
   wherein the alkali metal removing step comprises a machine grinding step of mechanically grinding the surface area on the sputtering surface side and an ultra-sonic washing step of ultra-sonically washing the surface area on the sputtering surface side.

**Patentansprüche**

1. Sputtertarget mit einer Zusammensetzung umfassend:

   5 Atom% oder mehr und 60 Atom% oder weniger Ga und
   0,01 Atom% oder mehr und 5 Atom% oder weniger Alkalimetall als Metallkomponenten; optional ein oder mehrere Metallelemente ausgewählt aus In, Al, Ag, Zn, Sn, Bi, Sb und Mg als Metallkomponenten in einem Bereich von insgesamt 0,1 Atom% oder mehr und 5,0 Atom% oder weniger;

   und als Rest Cu einschließlich unvermeidbarer Verunreinigungen, wobei
   eine Alkalimetallkonzentration auf einer Oberfläche auf einer Sputterflächenseite weniger als 80% der Alkalimetallkonzentration innerhalb des Targets beträgt.

2. Sputtertarget gemäß Anspruch 1, wobei die Alkalimetallkonzentration auf der Sputterfläche 1 Atom% oder weniger beträgt.

3. Sputtertarget gemäß Anspruch 1 oder 2, wobei eine relative Dichte 90% oder mehr beträgt.

4. Sputtertarget gemäß einem der Ansprüche 1 bis 3, wobei eine arithmetische Durchschnittsrauheit Ra der Sputterfläche 1,6 µm oder weniger beträgt.

5. Verfahren zur Herstellung des Sputtertargets gemäß einem der Ansprüche 1 bis 4, das Verfahren umfassend:

   einen Misch- und Zerkleinerungsschritt des Mischens und Zerkleinerns eines Rohmaterialpulvers enthaltend Cu und Ga und eines Alkalimetallverbindungspulvers, um ein gemischtes Pulver zu erhalten;
   einen Sinterschritt des Erhaltens eines gesinterten Materials durch Sintern des gemischten Pulvers, erhalten im Misch- und Zerkleinerungsschritt; und
   einen Alkalimetallentfernungsschritt des Entfernens eines Alkalimetalls auf einer Oberfläche auf der Sputterflächenseite des erhaltenen gesinterten Materials,
   wobei der Alkalimetallentfernungsschritt einen maschinellen Schleifschritt des mechanischen Schleifens der Oberfläche auf der Sputterflächenseite und einen Ultraschall-Waschschritt des Waschens der Oberfläche auf der Sputterflächenseite mit Ultraschall umfasst.

**Revendications**

1. Cible de pulvérisation présentant une composition comprenant : 5 % at ou plus et 60 % at ou moins de Ga, et 0,01 % at ou plus et 5 % at ou moins d'un métal alcalin, en tant que composants métalliques ; facultativement, un ou plusieurs des éléments métalliques sélectionnés parmi In, Al, Ag, Zn, Sn, Bi, Sb, et Mg en tant que composants métalliques dans une plage de 0,1 % at ou plus et 5,0 % at ou moins au total ;
   et le reste étant Cu incluant des impuretés inévitables, dans laquelle
   une concentration du métal alcalin sur une surface sur un côté surface de pulvérisation est inférieure à 80 % d'une concentration du métal alcalin à l'intérieur de la cible.

2. Cible de pulvérisation selon la revendication 1, dans laquelle la concentration en métal alcalin sur la surface de pulvérisation est de 1 % at ou moins.

3. Cible de pulvérisation selon la revendication 1 ou 2, dans laquelle une densité relative est de 90 % ou plus.

4. Cible de pulvérisation selon l'une quelconque des revendications 1 à 3, dans laquelle une rugosité moyenne arithmétique Ra de la surface de pulvérisation est de 1,6 µm ou moins.

5. Procédé de fabrication de la cible de pulvérisation selon l'une quelconque des revendications 1 à 4, le procédé comprenant :

une étape de mélange et de broyage consistant à mélanger et à broyer une poudre de matière première incluant du Cu et du Ga, et une poudre de composé de métal alcalin pour obtenir une poudre mélangée ;

une étape de frittage consistant à obtenir un matériau fritté par le frittage de la poudre mélangée obtenue à l'étape de mélange et de broyage ; et

une étape d'élimination de métal alcalin consistant à éliminer un métal alcalin sur une surface sur le côté surface de pulvérisation du matériau fritté obtenu,

dans lequel l'étape d'élimination de métal alcalin comprend une étape de meulage consistant à meuler mécaniquement la surface sur le côté surface de pulvérisation et une étape de lavage par ultrasons consistant à laver par ultrasons la surface sur le côté surface de pulvérisation.

FIG. 1

```
                        ┌─────────────────────────────────────┐
                        │  Cu-Ga ALLOY POWDER PREPARATION STEP │──S01
                        └─────────────────────────────────────┘
                                         │
                                         ▼
┌──────────────────┐   ┌──────────────────────────┐   ┌──────────────┐
│ ALKALINE METAL   │   │    Cu-Ga ALLOY POWDER    │   │  Cu POWDER   │
│ COMPOUND POWDER  │   └──────────────────────────┘   └──────────────┘
└──────────────────┘              │
        │                         ▼                         │
        └──────────┐   ┌─────────────────────────┐   ┌──────┘
                   ▼   ▼                         ▼   ▼
                ┌─────────────────────────────────────┐
                │        MIX AND CRUSHING STEP         │──S02
                └─────────────────────────────────────┘
                                 │
                                 ▼
                ┌─────────────────────────────────────┐
                │          RAW MATERIAL POWDER         │
                └─────────────────────────────────────┘
                                 │
                                 ▼
                ┌─────────────────────────────────────┐
                │           SINTERING STEP             │──S03
                └─────────────────────────────────────┘
                                 │
                                 ▼
                ┌─────────────────────────────────────┐
                │            WORKING STEP              │──S04
                └─────────────────────────────────────┘
                                 │
                                 ▼
          ┌ ─ ─ ─ ─ ─ ─ ─ ─ ─ ─ ─ ─ ─ ─ ─ ─ ─ ─ ─ ─ ┐
                                           S51         ──S05
          │  ┌─────────────────────────────────────┐ │
             │        MACHINE GRINDING STEP         │
          │  └─────────────────────────────────────┘ │
                             │
          │                  ▼            S52          │
             ┌─────────────────────────────────────┐
          │  │       ULTRA-SONIC WASHING STEP       │ │
             └─────────────────────────────────────┘
          └ ─ ─ ─ ─ ─ ─ ─ ─ ─ ─ ─ ─ ─ ─ ─ ─ ─ ─ ─ ─ ┘
                                 │
                                 ▼
                ┌─────────────────────────────────────┐
                │          SPUTTERING TARGET           │
                └─────────────────────────────────────┘
```

FIG. 2

FIG. 3

**EP 3 415 658 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016021644 A
- JP 2017016740 A
- WO 2011083647 PCT
- US 20150332901 A1